# EUROPÄISCHE PATENTSCHRIFT

(11) **EP 2 408 277 B1**
(45) Veröffentlichungstag und Bekanntmachung des Hinweises auf die Patenterteilung: **17.02.2016**
(21) Anmeldenummer: 10007390.7
(22) Anmeldetag: 16.07.2010
(51) Int. Cl.: H05K 1/02, H05K 1/03, H01H 85/041, H01H 85/02, H01H 69/02, H05K 1/16, H01H 85/046

(54) **Sicherungselement**
Fuse element
Élément fusible

(43) Veröffentlichungstag der Anmeldung: 18.01.2012
(73) Patentinhaber: Schurter AG, 6002 Luzern (CH)
(72) Erfinder: Blättler, Hans-Peter, 6043 Adligenswil (CH); Straub, Peter, 6317 Oberwil/Zug (CH); Ramos, José, 6033 Buchrain (CH)
(74) Vertreter: Niedmers, Ole

(56) Entgegenhaltungen:
- EP-A1- 0 893 947
- EP-A1- 0 957 513
- EP-A1- 1 045 625
- EP-A2- 0 484 703
- WO-A2-2006/091938
- DE-A1-102004 063 035
- US-A- 2 166 174
- US-A- 5 914 649
- US-A- 6 043 966
- US-A1- 2004 190 269
- "RO4000 Series High Frequency Circuit Materials", Rogers Coorporation Advanced Circuit Materials Division , 2006, XP002615325, Gefunden im Internet: URL:http://www.sbcinc.com/pdf/rogers/4000. PDF [gefunden am 2010-12-22]
- "THERMALLY CONDUCTIVE MULTILAYERABLE EPOXY LAMINATE AND PREPREG", Arlon Incorporated , 2009, XP002615326, Gefunden im Internet: URL:http://www.arlon-med.com/91ML.pdf [gefunden am 2010-12-22]
- "Pb Free RoHS Compliant Solutions", DDi Corporate Headquarters , 2010, XP002615327, Gefunden im Internet: URL:http://www.ddiglobal.com/technology/ro hs.cfm [gefunden am 2010-12-27]
- HITACHI CHEMICAL: 'High Tg Glass Epoxy Multilayer Material - MCL-E-679 Type(W)', [Online] 2012, Gefunden im Internet: <URL:http://www.hitachi-chem.co.jp/english/ products/bm/b02/001.html> [gefunden am 2012-12-06]

## Beschreibung

Die Erfindung betrifft ein Sicherungselement, insbesondere geeignet zur Verwendung bei in Multilayertechnik aufgebauten elektrischen und/oder elektronischen Schaltungen, umfassend ein insbesondere in der Multilayertechnik verwendbares Leiterplattenträgermaterial, das mit einem Metall bzw. einer Metallegierung beschichtet ist, aus dem bzw. der die Sicherung mittels photolithographischer und/oder drucktechnischer Bebilderungstechniken und nachfolgender Ätz- oder Gravierprozesse generiert wird.

Leiterplatten, wie sie in der Fertigung elektronischer aber auch elektrischer Schaltungen verwendet werden, ob nun in klassischer ein- oder zweiseitiger Beschichtung mit leitenden Werkstoffen zur Ausbildung von Leiterbahnen, aber auch in der sog. Multilayertechnik, in denen vielschichtig ausgebildete Leiterplatten verwendet werden, werden mit allen nur denkbaren aktiven und passiven elektronischen bzw. elektrischen Bauelementen bestückt, wobei diese Bestückung heutzutage regelmäßig mit Bestükkungsautomaten erfolgt. Alle die dabei herangezogenen aktiven und passiven elektrischen und elektronischen Elemente müssen aus Gründen der einheitlichen Bestükkungsvorgänge mit Bestückungsautomaten im Hinblick auf ihren Aufbau und ihre Handhabbarkeit zur automatischen Bestückung geeignet sein.

Ein passives Element für diese Anordnung auf Leiterplatten bzw. Leiterplattenträgern bilden Sicherungselemente, die in einer Vielzahl bei elektrischen und elektronischen Schaltungen verwendet werden, die mittels der vorbeschriebenen Leiterplatten bzw. Leiterplattenträger zu funktionsfähigen Schaltungen konfiguriert werden. Im Stand der Technik sind neben als gesonderte Elemente ausgebildeten Sicherungselementen auch solche bekannt, die aus den gleichen Materialien wie in der Leiterplattentechnik üblich realisiert werden, d.h. die Sicherungen werden durch entsprechend berechnete und dimensionierte Querschnitte aus dem Werkstoff, der die elektrischen Leiter auf den Leiterplattenträgern bildet, durch Ätz- oder Gravierverfahren herausgebildet, d.h. die Sicherung selbst besteht als bisweilen integraler Bestandteil der elektrischen bzw. elektronischen Schaltung aus dem Leiterwerkstoff wie z.B. Kupfer oder Kupferlegierungen, das bzw. die die übrigen Leiterbahnen ebenfalls bildet. Der Leiterwerkstoff kann z.B. auch Silber oder eine Silberlegierung sein, es sind aber auch alle anderen Metalle und Metallegierungen zur Ausbildung der Leiterbahnen bzw. des Leiterwerkstoffs möglich, soweit sie die gattungsgemäßen Forderungen erfüllen.

Ein wesentliches Problem bei der Ausbildung von Sicherungselementen bei den auf den Leiterplattenträger auflaminierten Metallen bzw. Metallegierungen, bspw. Kupfer oder Kupferlegierungen, liegt darin, daß das eigentliche Leiterplattenmaterial, aus dem der Leiterplattenträger besteht, in der Regel aus mit Epoxidharz verstärktem, gewobenem Glasgewebe besteht, einen anderen Temperaturausdehnungskoeffizienten aufweist als bspw. das Material der Leiter, bspw. Kupfer. Der Ausdehnungskoeffizient des beispielhaft vorerwähnten Epoxidharzes, das mit Glasgewebe verstärkt ist, liegt im Bereich von 14 bis 17 ppm/K, während der Ausdehnungskoeffizient z.B. von Kupfer, das die Leiterbahnen bildet, im Bereich von 17 ppm/K liegt. Ein Nachteil der bekannten Leiterplattenträger bzw. des Leiterplattenträgermaterials, was im allgemeinen für die Herstellung mit elektrischen und elektronischen Komponenten bestückten Leiterplatten bisher herangezogen wird, ist, daß die Betriebstemperaturen bisheriger Leiterplattenträgermaterialien regelmäßig nur Temperaturen unter 200° C zuließen, denn höhere Betriebstemperaturen schädigen das Leiterplattenträgermaterial. Dieses verliert in Folge zu hoher Temperaturen an Festigkeit und es kommt zu einer Delamination und letztendlich zur Dekomposition und Verkohlung des Polymers. Dadurch entstehen leitfähige, relativ niederohmige Schichten, woraus wiederum die nachteilige Folge erwächst, daß die minimal erforderlichen Isolationswiderstände derartig aufgebauter Sicherungen bzw. Sicherungselemente unterschritten werden.

Die Patentschriff US 5 914 649 A offenbart dem Gegenstand gemäss des Oberbegriffs von Anspruch 1

Bei einem anderen im Stand der Technik bekannten Typ an Sicherungen dient als Basis eine Al₂O₃-Keramik, die noch bei sehr viel höheren Temperaturen als Sicherungen auf der Basis des vorbeschriebenen Leiterplattenträgermaterials stabil sind, diese Sicherungen auf Al₂O₃-Keramik weisen allerdings einen Temperaturausdehnungskoeffizienten von in der Regel unter 8 ppm/K auf, was sich wiederum ebenfalls negativ auf die Stabilität der Sicherung und somit der gesamten elektrischen bzw. elektronischen Schaltung auswirkt, da zwischen dem eigentlichen Leiterplattenträgermaterial und der Keramik Spannungen auftreten, die Risse in der Keramik erzeugen und diese beschädigen und unbrauchbar machen.

Hinzukommt noch, daß viel Wärmeenergie vom eigentlichen Sicherungselement in die thermisch sehr gut leitende Keramik fließt. Sicherungen mit kleinen Nennströmen und flinker Charakteristik sind mit den beiden beispielhaft vorangehend vorgestellten Materialien nur schwierig zu realisieren.

Es ist somit Aufgabe der vorliegenden Erfindung, ein Sicherungselement zu schaffen, daß auch integral in dem Metall oder der Metallegierung, das bzw. die auf einem konventionellen Leiterplattenträger oder einem Multilayerleiterplattenträger aufgebracht ist, ausgebildet werden kann, das geeignet ist, hohen Betriebstemperaturen auch über 200° C stabil standzuhalten, denen die elektronische Schaltung einschl. des Leiterplattenträgermaterials, auf dem diese aufgebracht sind, ausgesetzt sind, wobei eine derartige Sicherung befähigt sein soll, ebenfalls hohen Umgebungstemperaturen standzuhalten und auch dabei eine hohe Isolationsfestigkeit aufweisen soll. Eine derartige Sicherung soll zudem mittels der Fertigungstechniken, wie sie bei Leiterplatten zur Aufnahme elektrischer und elektronischer Elemente verwendet werden, ebenfalls gefertigt werden können.

Gelöst wird die Aufgabe durch ein Sicherungselement gemäss Anspruch 1.

Der Vorteil der erfindungsgemäßen Lösung besteht im wesentlichen darin, daß eine bis in höchste Umgebungstemperaturen für elektrische bzw. elektronische Schaltungen stabile Isolationsfestigkeit der Sicherung gewährleistet ist und die ein Strom-Zeit-Verhalten zeigt, das sich von den bisherigen, im Stand der Technik angebotenen Lösungen zur Ausbildung von Sicherungen weit positiv abhebt und zudem auch die Werkstoff- und Herstellungskosten gegenüber den aus dem Stand der Technik bekannten, gattungsgemäßen Sicherungen erheblich vermindert werden können.

Gem. einer vorteilhaften Ausführungsform des Sicherungselements ist der metallische Werkstoff oder die Metallegierung, aus dem bzw. der die Sicherung generiert wird, Kupfer oder eine Kupferlegierung, was den Vorteil hat, daß auch in bezug auf die Ausbildung des Sicherungselementes die Techniken der Herstellung der endgültigen Ausbildung der Leiterplatten entsprechend der darauf aufzunehmenden elektrischen und/oder elektronischen Schaltung bzw. Komponenten dafür nicht verlassen werden müssen. Das gleiche gilt im wesentlichen auch, wenn der metallische Werkstoff oder die Metallegierung, aus dem bzw. der die Sicherung generiert wird Silber oder eine Silberlegierung ist oder ein beliebiges geeignetes Metall oder eine beliebige geeignete Metallegierung. Die Leiterbahnen, die auch das Sicherungselement bilden, sollten auch selbst wieder aus wenigstens einer zweilagigen Schichtung aus den vorbeschriebenen Metallen bzw. Metallegierungen sein. Die äußere Schicht hat dann die Funktion einer Deckschicht oder eines Mantels für den darunterliegenden Werkstoff.

Eine wesentliche Komponente zur Ausbildung des erfindungsgemäßen Sicherungselements ist der Werkstoff des Leiterplattenträgers, ob nun in Form einer konventionell ausgebildeten Leiterplatte oder einer in Multilayertechnik ausgebildeten Mehrzahl von Leiterplatten. Vorteilhaft ist es dabei, den Werkstoff des Leiterplattenträgers so zu wählen, daß das Leiterplattenträgermaterial wenigstens aus einem hitzegehärteten, glasfaserverstärkten Kohlenwasserstoff/Keramik-Laminat aufgebaut ist, wobei derartiges Material bspw. von der Rogers Corporation unter der Marke R04000 im Handel verfügbar ist.

Bei einer zweiten vorteilhaften Ausführungsform des Sicherungselements besteht das Leiterplattenträgermaterial vorzugsweise wenigstens aus einem mit Keramik angereicherten, temperaturleitenden Epoxidharzlaminat, wobei dieses Material unter der Bezeichnung Arlon91ML der Arlon Corporation bekannt und im Handel verfügbar ist.

Es sei aber ausdrücklich darauf hingewiesen, daß die beiden vorstehend aufgeführten Materialien, aus denen das Leiterplattenträgermaterial besteht, die hier nur beispielhaft als Möglichkeit aufgezeigt sind, die im Handel erhältlich sind, für die Ausbildung der Erfindung verwendbar sind.

Wie eingangs erwähnt, ist die Temperaturstabilität, besser Temperaturbeständigkeit, des Sicherungselementes ein wesentlicher Faktor für das Geeignetsein, integral mit der Leiterplatte, d.h. im gleichen Arbeitsgang mit der Herstellung von dieser, ausgebildet werden zu können. Wenn ein klassisch aufgebauter Leiterplattenträger verwendet wird und in dem darauf aufkaschierten Metall bzw. der Metallegierung das eigentliche Sicherungselement ausgebildet wird, liegt das Sicherungselement quasi mit einer Seite frei, so daß das Sicherungselement auf diesem Weg Wärme an die Umgebung abgeben kann. Wird jedoch die Sicherung in einem Multilayersystem aus mehreren aneinanderliegenden Leiterplattenträgern verwendet, so ist das eigentliche Sicherungselement, etwas unscharf auch Schmelzleiter genannt, in dem besagten Multilayersystem komplett eingebettet bzw. komplett einlaminiert. Dadurch ist die Wärmeabgabe des Sicherungselements infolge seiner Erwärmung infolge großer durch das Sicherungselement hindurchfließender Ströme behindert.

Um auch für einen derartigen Fall eine gute Wärmeabgabe zu gewährleisten, ist es vorteilhaft, im Bereich des Ortes eines ersten Leiterplattenträgers eines Multilayersystems, an dem die Sicherung im Metall oder in der Metallegierung ausgebildet ist, in einem auf dem ersten Leiterplattenträger benachbart aufliegenden zweiten Leiterplattenträger in Form einer Aussparung im zweiten Leiterplattenträger einen Hohlraum auszubilden.

Unter Ausnutzung dieses vorteilhaften Prinzips zur Schaffung einer unbehinderten Wärmeabgabe des eigentlichen Sicherungselementes kann es weiterhin vorteilhaft sein, im Bereich des Ortes eines ersten Leiterplattenträgers, an dem die Sicherung im Metall oder in der Metallegierung ausgebildet ist, sowohl in einem auf dem ersten Leiterplattenträger benachbart aufliegenden zweiten Leiterplattenträger als auch im Bereich des Ortes des ersten Leiterplattenträgers, an dem die Sicherung ausgebildet ist, in Form jeweiliger Aussparungen jeweils einen Hohlraum auszubilden. Das hat den außerordentlichen Vorteil, daß faktisch das Sicherungselement (Schmelzleiter) an seinen beiden Seiten in der Multilayerschicht mit einem benachbarten Hohlraum versehen ist, so daß die durch hohen Stromfluß durch das Sicherungselement entstehende Wärme zu beiden Seiten abgeführt werden kann.

Dieses Prinzip der Ausbildung der eigentlichen Sicherung (Schmelzleiter) benachbarter Hohlräume kann analog auch bei mehr als zwei aufeinanderpositionierten Leiterplattenträgern konventionell oder in Multilayertechnik realisiert werden.

Der Hohlraum ist in vielen Fällen an der dem Sicherungselement abgewandten Seite offen, so daß zirkulierende Luft oder ein gasförmiges Umgebungsmedium auch das Sicherungselement erreichen kann, entweder von einer Seite, erste vorbeschriebene Möglichkeit, oder von beiden Seiten, zweite vorbeschriebene Möglichkeit.

Es kann aber auch für bestimmte Anwendungszwecke vorteilhaft sein, den Hohlraum bzw. die Hohlräume an der dem Sicherungselement abgewandten Seite mit einer Schicht abzuschließen.

Diese Schicht kann mehrere Aufgaben erfüllen, d.h. bspw. verhindern, daß ein Lichtbogen oder geschmolzene Bestandteile der Sicherung an die Umgebung aus dem unmittelbaren Bereich der Sicherung heraustreten können, und sie kann gleichermaßen bei der Entstehung eines Lichtbogens das Austreten des Lichtbogens aus dem Hohlraum in die Umgebung verhindern.

Um bspw. hohe Drücke bei durch die Sicherung fließenden Strömen durch Volumenvergrößerung der Luft im Hohlraum aufnehmen zu können, ohne daß diese Schicht birst, ist es vorteilhaft, diese Schicht als flexible Schicht auszubilden, und zwar nach Art einer Membran.

Die Membran soll zwar einen Luftaustausch in den Hohlraum hinein bzw. aus dem Hohlraum heraus gestatten, sie verhindert aber, daß geschmolzene Bestandteile der Sicherung aus dem Hohlraum austreten können und verhindert das Entflammen von dem Sicherungselement benachbarten Bauelementen und dem Multilayersystem insgesamt.

Die Schicht, die regelmäßig vorzugsweise eine folienartige Struktur aufweist, d.h. lediglich eine geringe Dikke aufweist, kann vorzugsweise mit einer zusätzlichen Metallschicht versehen sein. Durch die Metallisierung der Schicht kann diese noch zusätzlich gegen thermische und mechanische Belastung stabilisiert werden, so daß sie den voranstehend beispielhaft aufgeführten Belastungen noch stärker widerstehen kann.

Gem. einer weiteren, noch anderen vorteilhaften Ausführungsform des Sicherungselementes weist das das eigentliche Schmelzteil der Sicherung bildende Metall bzw. die Metallegierung eine Mehrzahl von Durchgangslöchern auf, es kann aber auch vorteilhaft sein, den Leiterplattenträger im Bereich des Schmelzteils der eigentlichen Sicherung alternativ oder zusätzlich mit einer Mehrzahl von Durchgangslöchern zu versehen, wodurch die Wärmeleitfähigkeit des Metalls bzw. der Metallegierung und/oder die Wärmeleitfähigkeit des eigentlichen Leiterplattenträgermaterials beeinflußt werden kann. Dadurch kann bspw. die Zeit-Strom-Kennlinie der Sicherung flinker oder träger gestaltet werden. Zudem kann durch diese Maßnahme das Strom-Zeit-Integral beeinflußt werden.

Das Sicherungselement kann bevorzugt derart weitergebildet werden, daß wenigstens ein Hohlraum mit einem Isolationsmittel wenigstens teilweise angefüllt ist, wobei dieses Isolationsmittel im wesentlichen die Funktion hat, eine Flammbildung bei Schmelzen der Sicherung zu verhindern, d.h. als Löschmittel zu wirken. Isolationsmittel dieser Art können bspw. Silikon, Sand, Luft aber auch die Materialien sein, aus denen die oben beschriebenen bevorzugten Materialien aufgebaut sind, d.h. aus denen das Leiterplattenträgermaterial selbst besteht. Durch das Isolationsmittel kann zudem ein beim Schmelzen der Sicherung normalerweise entstehen könnender Lichtbogen weitgehend unterdrückt werden.

Grundsätzlich gibt es für die Ausbildung des erfindungsgemäßen Sicherungselements keine Beschränkungen der mechanischen bzw. geometrischen Größen. Wenn aber das erfindungsgemäße Sicherungselement genauso wie andere elektrische und/oder elektronische Bauelemente auf konventionellen Leiterplattenträgern oder auf Leiterplattenträgern nach Art der erwähnten Multilayertechnik aufgenommen werden soll, ist es vorteilhaft, daß die Fläche, in der die Schicht ausgebildet ist, im wesentlichen die Fläche des Körpers des Sicherungselementes in zwei Dimensionen bestimmt. D.h. mit anderen Worten, daß die Größe der Fläche der Schicht in der x-y-Ebene die Größe der Fläche des Sicherungselements in der Draufsicht entspricht. Praktischerweise kann die Fläche der Fläche entsprechen, wie sie bspw. bei typischen integrierten Schaltkreisen mit rechteckiger, quadratischer aber auch kreisförmiger Form anzutreffen ist.

Die Höhe des Sicherungselements wird vorzugsweise wenigstens durch die Dicke zweier aufeinanderliegender Leiterplattenträger zzgl. der Dicke des metallischen Schmelzteils des die eigentliche Sicherung bildenden Leiters, d.h. in einer dritten Dimension bestimmt. Die Höhe bzw. die Gesamtdicke kann sich bei diskretem, nicht in konventioneller Leiterplattentechnik oder Multilayertechnik aufgebauten Sicherungselementen an der Höhe bzw. der Dicke typischer Bauformen von integrierten Schaltkreisen orientieren.

Bei der vorangehend angedeuteten diskreten Bauform von Sicherungselementen gem. der Erfindung weisen gem. einer weiteren anderen vorteilhaften Ausführungsform des Sicherungselementes beide Enden des Schmelzteils des Sicherungselementes Verbindungskontakte auf, über die das Sicherungselement mit dem übrigen Teil der elektrischen und/oder elektronischen Schaltung auf dem Leiterplattenträger bzw. Multilayerträger verbunden werden kann, oder aber auch mit gesonderten Leitungen, mit denen beide Pole der Sicherung verbunden werden können.

Schließlich kann bei dem erfindungsgemäßen Sicherungselement, wenn es, wie erwähnt, eine im wesentlichen 3-dimensionale Ausbildung aufweist, d.h. als diskret aufgebautes Sicherungselement konzipiert ist, der das Sicherungselement bildende Körper die vorerwähnten Verbindungskontakte derart ausgestaltet aufweisen, daß diese mittels Durchkontaktierungsverbindungen mit den beiden Enden (Polen) des Schmelzleiters verbunden sind.

Die Erfindung wird nun unter Bezugnahme auf die nachfolgenden schematischen Zeichnungen anhand zweier Ausführungsbeispiele im einzelnen beschrieben. Darin zeigen:
- Fig. 1: in stark vergrößerter Darstellung in der Seitenansicht ein Sicherungselement gem. der Erfindung, bei dem über dem die eigentliche Sicherung bildenden Schmelzleiter ein Hohlraum ausgebildet ist,
- Fig. 2: eine Darstellung gem. Fig. 1, jedoch in perspektivischer Darstellung,
- Fig. 3: eine Darstellung eines Sicherungselementes in der Seitenansicht gem. Fig. 1, jedoch eine zweite Ausführungsform zeigend, bei der oberhalb und unterhalb des die eigentliche Sicherung bildenden Schmelzleiters ein Hohlraum ausgebildet ist, und
- Fig. 4: in perspektivischer Darstellung die in Fig. 3 dargestellte zweite Ausführungsform des Sicherungselementes, bei der auch noch Durchkontaktierungen als leitende Verbindungen zu einem der Pole bzw. Enden der Sicherung sichtbar sind.

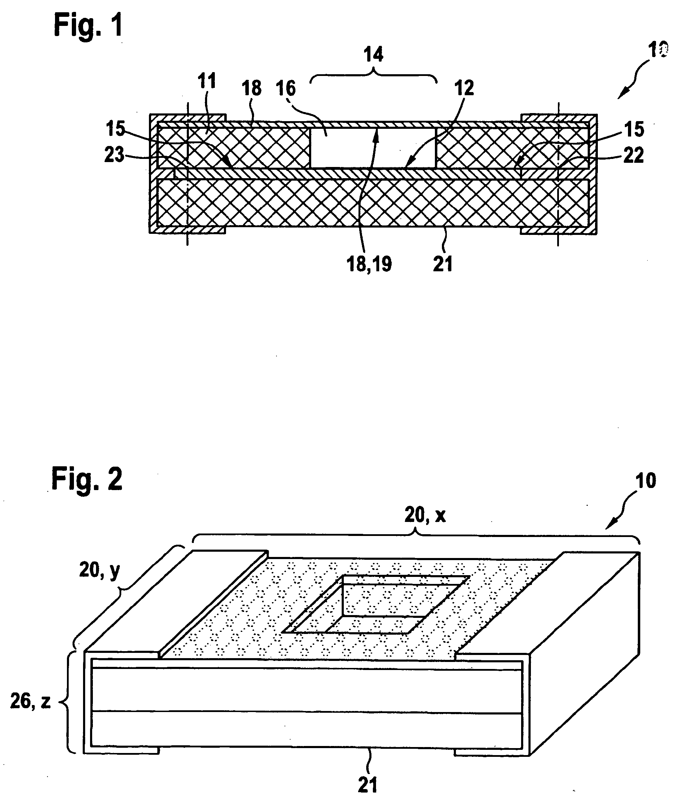

Es wird zunächst auf die Darstellungen der Fig. 1 und 2 Bezug genommen, in denen ein Sicherungselement 10 einer ersten Ausführungsform der Erfindung dargestellt ist.

Die Fig. 1 und 2 betreffen das Sicherungselement 10, bei dem auf einem Leiterplattenträger bzw. einem Leiterplattenträgermaterial 11 die erfindungsgemäße Sicherung 12 ausgebildet ist. Die Sicherung 12 wird auf dem Leiterplattenträger 11, der mittels eines Metalls oder einer Metallegierung 12 auf bekannte Weise durch einen Kaschiervorgang beschichtet ist, ausgebildet, wobei die Sicherung 12 mittels photolithographischer und/oder drucktechnischer Bebilderungstechniken, bspw. durch Siebdruck, und nachfolgender Ätz- oder Gravierprozesse generiert wird, wie das generell bei der Ausbildung von Leiterplatten zur Ausbildung der auf den Leiterplatten auszubildenden Leiterbahnen auf bekannte Weise erfolgt. Als Leiterplattenträgermaterial 11 bzw. Leiterplattenträger sind hier sowohl konventionell aufgebaute Leiterplattenträger mit ein- und/oder zweiseitiger Beschichtung mit Metall bzw. Metallegierungen gemeint als auch die bekannten Leiterplattenträger, die in Multilayertechnik ausgebildet sind bzw. dafür verwendet werden.

Als Leiterplattenträgermaterial wird ein wenigstens hochwärmestabiler Werkstoff verwendet, wobei wenigstens dessen Wärmeausdehnungskoeffizient im wesentlichen analog des Wärmeausdehnungskoeffizienten des Metalls oder der Metallegierung 25 verläuft, aus dem bzw. der die Sicherung 12 ausgebildet ist.

Es sei darauf hingewiesen, daß der metallische Werkstoff oder die Metallegierung, aus der die Sicherung 12 generiert wird, regelmäßig Kupfer oder eine Kupferlegierung ist, es sei aber ausdrücklich darauf hingewiesen, daß auch andere Metalle bzw. Metallegierungen, bspw. Silber und Silberlegierungen, die sich zur Ausbildung von elektrischen Sicherungen 12 der gattungsgemäßen Art eignen, herangezogen werden können. Es können auch mehrschichtige Strukturen, bspw. als erste Schicht Kupfer bzw. eine Kupferlegierung und darauf eine Schicht aus Silber bzw. Silberlegierung die Sicherung 12 bilden. Auch vielschichtige Strukturen mit beliebigen geeigneten Metallen bzw. Metallegierungen sind im Rahmen der Erfindung liegend möglich.

Oberhalb oder unterhalb der auf den Leiterplattenträger 11 aufkaschierten Schicht aus Metall bzw. einer Metallegierung 15, aus der sowohl die Leiterbahnen einer Leiterplatte ausgebildet werden können als auch im vorliegenden Fall, bei dem die eigentliche Sicherung 12 auf oben beschriebene Weise ausgebildet ist, befindet sich im Bereich des Ortes 14, an dem die Sicherung 12 im Metall oder in der Metallegierung 15 ausgebildet ist, ein Hohlraum 16. Der Hohlraum 16 ist mittels einer Schicht 15 mit folienartiger Struktur wenigstens teilweise ver- bzw. abgeschlossen, und zwar an der der eigentlichen Sicherung 12 abgewandten Seite 17. Die Schicht 18 kann auch eine für bestimmte gasförmige Medien, bspw. Luft, in beiden Richtungen durchlässige Membran sein, so daß bspw. die eigentliche Sicherung 12 durch Luftzirkulation beaufschlagt werden kann, es ist aber auch entweder alternativ oder zusätzlich möglich, die Schicht 18 mit einer zusätzlichen Metallschicht 19 zu versehen, bspw. mittels Aufdampfen von Metall, so daß das gasförmige Umgebungsmedium immer noch hindurchtreten kann, ein elektrischer Lichtbogen, der sich bspw. bei der Sicherung 12 infolge Überlast nach dem Schmelzen des Schmelzteils der Sicherung bildet, nicht aus dem Hohlraum 16 austreten kann.

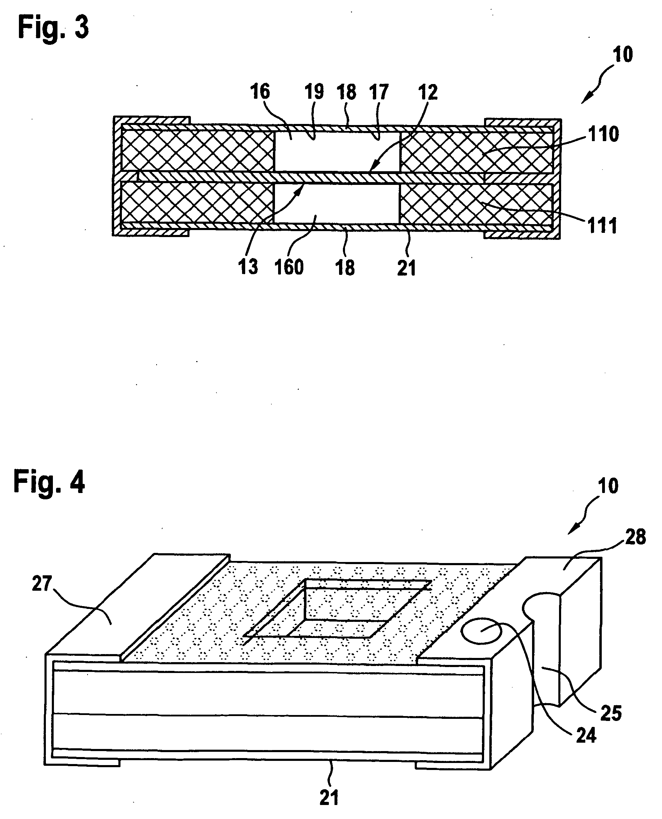

Im Bereich der Sicherung 12 kann der Leiterplattenträger 11, was gleichermaßen für die Leiterplattenträger 110, 111 gilt, die weiter unten im Zusammenhang mit der zweiten Ausführungsform des Sicherungselementes gem. den Fig. 3 und 4 beschrieben werden, können hier nicht dargestellte Durchgangslöcher ausgebildet sein, die bspw. mittels Lasereinrichtungen ausgeführt werden können, mittels der die Zeit-Strom-Kennlinie der Sicherung 12 flinker oder träger gestaltet werden kann, wobei auch das Strom-Zeit-Integral durch diese Maßnahme beeinflußbar ist. Gleichermaßen kann das den Schmelzteil der Sicherung bildende Metall bzw. die Metallegierung ebenfalls eine Mehrzahl derartiger Durchgangslöcher aufweisen, so daß auch dadurch entweder alternativ oder zusätzlich eine Beeinflussung der vorgenannten Parameter möglich ist. Der Hohlraum 16 und/oder der Hohlraum 16, 160 der Ausführungsform des Sicherungselementes 10 gem. den Fig. 3 und 4 kann bzw. können mit einem hier nicht dargestellten Isolationsmittel wenigstens teilweise ausgefüllt werden, wobei dieses Isolationsmittel bspw. Sand, Silikon, Quarzmehl oder sonstige geeignete elektrisch nicht leitende Löschmittel sein können. Auch Glas, Sand, Quarz oder Keramik, bspw. in Kugelform, kann wenigstens teilweise in den Hohlraum 16 bzw. die Hohlräume 16, 160 eingefüllt werden. Auch Mischungen der vorgenannten Materialien sind möglich.

Bei der Ausführungsform des Sicherungselementes 10 gem. den Fig. 3 und 4 ist oberhalb und unterhalb der Sicherung 12 in dem Leiterplattenträger 110, 111 ein Hohlraum 16, 160 ausgebildet, so daß die mit dem Hohlraum 16 im Zusammenhang mit der Ausführungsform des Sicherungselements 10 im Zusammenhang mit der Darstellung der Fig. 1 und 2 beschriebenen, bewirkten Effekte hier quasi von beiden Seiten auf die Sicherung 12 einwirken können. Das gilt gleichermaßen auch für die Schicht 18, wie sie schon im Zusammenhang mit den Fig. 1 und 2 bei dem dort dargestellten Sicherungselement 10 beschrieben worden ist.

Ausgehend von den Darstellungen der Ausführungsform des Sicherungselementes 10 gem. den Fig. 3 und 4 wird auf eine hier nicht dargestellte Ausführungsform der Sicherungselemente 10 verwiesen, die bei gleichem Aufbau wie die in den Fig. 3 und 4 keinen benachbarten Hohlraum 16 aufweisen. Die beiden im wesentlichen parallel voneinander beabstandet angeordneten Sicherungen 12, 13 sind faktisch in den bzw. von benachbarten Leiterplattenträgern 110, 110 einlaminiert.

Es können auch nach diesem vorangehend beschriebenen Prinzip des Aufbaus vielschichtige Strukturen, d.h. nach dem Prinzip von Multilayerleiter-Plattenträgern aufgebaut werden, mit und ohne jeweilige benachbarte Hohlräume 16, 160.

Derartige Ausführungsformen der Sicherungselemente 10 bzw. der eigentlichen Sicherungen 12, 13 lassen auch den einfachen Aufbau - elektrisch - in Reihe und/oder parallel geschalteter Sicherungen zu.

Die durch die Länge X und die Breite Y, s. Fig. 2, aufgespannte Fläche 20 der Schicht 18 bestimmt im wesentlichen die Fläche des Körpers 21 des Sicherungselementes 10. Die Dicke 26 wird im wesentlichen durch zwei aneinanderliegende Leiterplattenträger 110, 111 zzgl. der Dicke des den metallischen Schmelzteil der Sicherung 12 bildenden Leiters, d.h. in der 3. Dimension Z, bestimmt. Das Volumen des Körpers 21 des Sicherungselementes 10 kann an sich beliebig ausgestaltet sein, bspw. in Form eines Quaders, eines Würfels oder auch eines Säulenabschnitts mit kreisförmigem Querschnitt. Beliebige andere geeignete Mischformen der Form des Volumens des Körpers 21 sind aber möglich. So kann der Körper 21 des Sicherungselementes 10 auch wie ein integraler Schaltkreis ausgebildet sein, wie er im Bereich elektrischer und/oder elektronischer Schaltungen allgemein bekannt ist.

Das Sicherungselement 10 gem. der Ausführungsform gem. den Fig. 3 und 4 weist, zu beiden Stirnseiten gegenüberliegend, metallische Anschlüsse 27, 28 auf, die quasi den Anschlußpol für das Sicherungselement 10 bilden. Die beiden Enden 22, 23 des eigentlichen Schmelzteils der Sicherung 12, in Fig. 1 als Kreuzungspunkt mit der dort verlaufenden vertikalen Linie, die strichpunktiert gezeichnet ist, sind mit Verbindungskontakten 24, 25 versehen, die als Durchkontaktierungen ausgebildet sein können, wie sie allgemein bei Leiterplatten für elektrische und/oder elektronische Schaltungen verwendet werden.

### Bezugszeichenliste

- 10: Sicherungselement
- 11: Leiterplattenträger, Leiterplattenträgermaterial
- 110: erster Leiterplattenträger / erstes Leiterplattenträgermaterial
- 111: zweiter Leiterplattenträger / zweites Leiterplattenträgermaterial
- 12: Sicherung
- 13: Sicherung
- 14: Ort
- 15: Metall / Metallegierung
- 16: Hohlraum
- 160: Hohlraum
- 17: Seite
- 18: Schicht
- 19: Metallschicht
- 20: Fläche
- 21: Körper (Sicherungselement)
- 22: Ende
- 23: Ende
- 24: Verbindungskontakt
- 25: Verbindungskontakt
- 26: Dicke
- 27: Anschluß (Pol)
- 28: Anschluß (Pol)

## Patentansprüche

1. Sicherungselement (10), insbesondere geeignet zur Verwendung bei in Multilayertechnik aufgebauten elektrischen und/oder elektronischen Schaltungen, umfassend ein insbesondere in der Multilayertechnik verwendbares, elektrisch isolierendes Leiterplattenmaterial, das mit einem Metall bzw. einer Metallegierung (15) beschichtet ist, aus dem bzw. der die Sicherung (12) mittels photolithographischer und/oder drucktechnischer Bebilderungstechniken und nachfolgender Ätz- oder Gravierprozesse generiert wird, **dadurch gekennzeichnet, daß** das Leiterplattenträgermaterial (11; 110, 111) wenigstens aus einem hitzegehärteten, glasfaserverstärkten Kohlenwasserstoff/Keramiklaminat besteht oder aus einem mit Keramik angereicherten, temperaturleitenden Epoxidharzlaminat besteht, wobei das Metall bzw. die Metallegierung in direktem Kontakt mit dem Leiterplattenmaterial steht.

2. Sicherungselement nach Anspruch 1, **dadurch gekennzeichnet, daß** der metallische Werkstoff oder die Metallegierung, aus der die Sicherung (12) generiert wird, Kupfer oder eine Kupferlegierung ist.

3. Sicherungselement nach Anspruch 1, **dadurch gekennzeichnet, daß** der metallische Werkstoff oder die Metallegierung, aus der die Sicherung (12) generiert wird, Silber oder eine Silberlegierung ist.

4. Sicherungselement nach einem oder mehreren der Ansprüche 1 bis 3, **dadurch gekennzeichnet, daß** die Sicherung (12) aus einer Mehrzahl von Schichten aus Metall oder einer Metallegierung gebildet wird.

5. Sicherungselement nach Anspruch 4, **dadurch gekennzeichnet, daß** eine äußere Schicht der Mehrzahl von Schichten aus Silber oder aus einer Silberlegierung gebildet wird.

6. Sicherungselement nach einem oder mehreren der Ansprüche 1 bis 5, **dadurch gekennzeichnet, daß** zum ersten Leiterplattenträger (110), an dem die Sicherung (12) im Metall oder in der Metallegierung ausgebildet ist, ein benachbart auf dem ersten Leiterplattenträger (110) aufliegender zweiter Leiterplattenträger (111) vorgesehen ist.

7. Sicherungselement nach einem oder mehreren der Ansprüche 1 bis 6, **dadurch gekennzeichnet, daß** im Bereich des Ortes (14) eines ersten Leiterplattenträgers (110), an dem die Sicherung (12) im Metall oder in der Metallegierung (15) ausgebildet ist, in einem auf dem ersten Leiterplattenträger (110) benachbart aufliegendem zweiten Leiterplattenträger (111) in Form einer Aussparung im zweiten Leiterplattenträger (111) ein Hohlraum (16) ausgebildet ist.

8. Sicherungselement nach einem oder mehreren der Ansprüche 1 bis 7, **dadurch gekennzeichnet, daß** im Bereich des Ortes (14) eines ersten Leiterplattenträgers (110), an dem die Sicherung (12) im Metall oder in der Metallegierung (15) ausgebildet ist, sowohl in einem auf dem ersten Leiterplattenträger (110) benachbart aufliegendem zweiten Leiterplattenträger (111) als auch im Bereich des Ortes (14) des ersten Leiterplattenträgers (110), an dem die Sicherung (12) ausgebildet ist, in Form jeweiliger Aussparungen jeweils ein Hohlraum (16, 160) ausgebildet ist.

9. Sicherungselement nach einem oder mehreren der Ansprüche 7 oder 8, **dadurch gekennzeichnet, daß** der Hohlraum (16) bzw. die Hohlräume (16, 160) an der der Sicherung (12) abgewandten Seite (17) mit einer Schicht (18) abgeschlossen sind.

10. Sicherungselement nach Anspruch 9, **dadurch gekennzeichnet, daß** die Schicht (18) eine Membran ist.

11. Sicherungselement nach Anspruch 9, **dadurch gekennzeichnet, daß** die Schicht (18) eine flexible Schicht (18) ist.

12. Sicherungselement nach einem oder mehreren der Ansprüche 9 bis 11, **dadurch gekennzeichnet, daß** die Schicht (18) eine folienartige Struktur aufweist.

13. Sicherungselement nach einem oder mehreren der Ansprüche 9 bis 12, **dadurch gekennzeichnet, daß** die Schicht (18) eine zusätzliche Metallschicht (19) aufweist.

14. Sicherungselement nach einem oder mehreren der Ansprüche 1 bis 13, **dadurch gekennzeichnet, daß** der Leiterplattenträger (11; 110, 111) wenigstens im Bereich des Schmelzteils der Sicherung (12) eine Mehrzahl von Durchgangslöchern aufweist.

15. Sicherungselement nach einem oder mehreren der Ansprüche 1 bis 14, **dadurch gekennzeichnet, daß** das den Schmelzteil der Sicherung (12) bildende Metall bzw. die Metallegierung (15) eine Mehrzahl von Durchgangslöchern aufweist.

16. Sicherungselement nach einem oder mehreren der Ansprüche 7 bis 15, **dadurch gekennzeichnet, daß** wenigstens ein Hohlraum (16; 160) mit einem Isolationsmittel wenigstens teilweise angefüllt ist.

17. Sicherungselement nach einem oder mehreren der Ansprüche 9 bis 16, **dadurch gekennzeichnet, daß** die Fläche (20), in der die Schicht (18) ausgebildet ist, im wesentlichen die Fläche des Körpers (21) der Sicherung (12) in der Ebene bestimmt.

18. Sicherungselement nach einem oder mehreren der Ansprüche 9 bis 17, **dadurch gekennzeichnet, daß** wenigstens die Dicke zweier aneinanderliegender Leiterplattenträger (110, 111) zzgl. der Dicke des den Schmelzteil des Sicherungselementes (10) bildenden Leiters die Dicke des Körpers (21) des Sicherungselementes (10) bestimmt.

19. Sicherungselement nach einem oder mehreren der Ansprüche 1 bis 18, **dadurch gekennzeichnet, daß** beide Enden (22, 23) des Schmelzteils des Sicherungselementes (10) mit Verbindungskontakten (24, 25) versehen sind.

20. Sicherungselement nach Anspruch 19, **dadurch gekennzeichnet, daß** bei einer 3-dimensionalen Ausbildung des das Sicherungselement (10) bildenden Körpers (21) die Verbindungskontakte (24, 25) mittels Durchkontaktierungsverbindungen mit den beiden Enden (22, 23) des Schmelzteils der Sicherung (12) verbunden sind.

## Claims

1. Fuse element (10), which is suitable in particular for use in electrical and/or electronic circuits which are constructed in multi-layer technology, comprising an electrically insulating circuit-board material which can be used in multi-layer technology and is coated with a metal or a metal alloy (15), from which the fuse (12) is produced by means of photolithographic and/or typographical imaging techniques and subsequent etching or engraving processes, **characterised in that** the circuit-board base material (11; 110, 111) comprises at least a heat-hardened, glass-fibre-reinforced hydrocarbon/ceramic laminate or of a heat-conducting epoxy resin laminate which is fortified with ceramic, the metal or metal alloy being in direct contact with the circuit-board material.

2. Fuse element according to claim 1, **characterised in that** the metal material or the metal alloy from which the fuse (12) is produced is copper or a copper alloy.

3. Fuse element according to claim 1, **characterised in that** the metal material or the metal alloy from which the fuse (12) is produced is silver or a silver alloy.

4. Fuse element according to one or more of claims 1 to 3, **characterised in that** the fuse (12) is formed of a plurality of layers of metal or a metal alloy.

5. Fuse element according to claim 4, **characterised in that** an outer layer of the plurality of layers is formed of silver or of a silver alloy.

6. Fuse element according to one or more of claims 1 to 5, **characterised in that** in addition to the first circuit-board base (100), on which the fuse (12) is formed in the metal or in the metal alloy, a second circuit-board base (111) which lies adjacent to the first circuit-board base (110) is provided.

7. Fuse element according to one or more of claims 1 to 6, **characterised in that**, in the region of the location (14) of a first circuit-board base (110), on which the fuse (12) is formed in the metal or in the metal alloy (15), a cavity (16) is formed in a second circuit-board base (111), which lies adjacent to the first circuit-board base (110), in the form of a recess in the second circuit-board base (111).

8. Fuse element according to one or more of claims 1 to 7, **characterised in that**, in the region of the location (14) of a first circuit-board base (110), on which the fuse (12) is formed in the metal or in the metal alloy (15), a cavity (16, 160) is formed both in a second circuit-board base (111), which lies adjacent to the first circuit-board base (110), and in the region of the location (14) of the first circuit-board base (110) on which the fuse is formed (12), respectively, in the form of respective recesses.

9. Fuse element according to claim 7 and/or claim 8, **characterised in that** the cavity (16) or the cavities (16, 160) are closed with a layer (18) on the side (17) thereof which is remote from the fuse (12).

10. Fuse element according to claim 9, **characterised in that** the layer (18) is a membrane.

11. Fuse element according to claim 9, **characterised in that** the layer (18) is a flexible layer (18).

12. Fuse element according to one or more of claims 9 to 11, **characterised in that** the layer (18) has a film-type structure.

13. Fuse element according to one or more of claims 9 to 12, **characterised in that** the layer (18) has an additional metal layer (19).

14. Fuse element according to one or more of claims 1 to 13, **characterised in that** the circuit-board base (11; 110, 111) has a plurality of through holes at least in the region of the melting part of the fuse (12).

15. Fuse element according to one or more of claims 1 to 14, **characterised in that** the metal or metal alloy (15) forming the melting part of the fuse (12) has a plurality of through holes.

16. Fuse element according to one or more of claims 7 to 15, **characterised in that** at least one cavity (16; 160) is filled at least partially with an insulating medium.

17. Fuse element according to one or more of claims 9 to 16, **characterised in that** the surface area (20) in which the layer (18) is formed substantially determines the surface area of the body (21) of the fuse (12) in the plane.

18. Fuse element according to one or more of claims 9 to 17, **characterised in that** at least the thickness of two circuit-board bases (110, 111) which are adjacent to one another plus the thickness of the conductor forming the melting part of the fuse element (10) determines the thickness of the body (21) of the fuse element (10).

19. Fuse element according to one or more of claims 1 to 18, **characterised in that** the two ends (22, 23) of the melting part of the fuse element (10) are provided with connection contacts (24, 25).

20. Fuse element according to claim 19, **characterised in that** in a three-dimensional design of the body (21) forming the fuse element (10), the connection contacts (24, 25) are connected to the two ends (22, 23) of the melting part of the fuse (12) by means of via connections.

## Revendications

1. Élément fusible (10), plus particulièrement approprié pour une utilisation dans des circuits électriques et/ou électroniques à structures multicouches, comprenant un matériau de circuit imprimé isolant électrique utilisable plus particulièrement dans la technologie multicouches, qui est revêtu d'un métal ou d'un alliage métallique (15) à partir duquel le fusible (12) est généré à l'aide de techniques d'imagerie photolithographique et/ou d'impression suivies de processus de décapage et de gravure, **caractérisé en ce que** le matériau de support de circuit imprimé (11 ; 110, 111) est constitué d'au moins un hydrocarbure/stratifié céramique durci à la chaleur et renforcé à l'aide de fibres de verre ou d'un stratifié de résine époxy enrichi en céramique et thermo-conducteur, le métal ou l'alliage métallique étant en contact direct avec le matériau de circuit imprimé.

2. Élément fusible selon la revendication 1, **caractérisé en ce que** le matériau métallique ou l'alliage métallique, à partir duquel le fusible (12) est fabriqué, est du cuivre ou un alliage de cuivre.

3. Élément fusible selon la revendication 1, **caractérisé en ce que** le matériau métallique ou l'alliage métallique, à partir duquel le fusible (12) est fabriqué, est de l'argent ou alliage d'argent.

4. Élément fusible selon l'une ou plusieurs des revendications 1 à 3, **caractérisé en ce que** le fusible (12) est constitué d'une pluralité de couches en métal ou en alliage métallique.

5. Élément fusible selon la revendication 4, **caractérisé en ce qu'**une couche externe de la pluralité de couches est constituée d'argent ou d'un alliage d'argent.

6. Élément fusible selon l'une ou plusieurs des revendications 1 à 5, **caractérisé en ce que**, pour le support de circuit imprimé (110), sur lequel le fusible (12) constitué de métal ou d'un alliage métallique est formé, un deuxième support de circuit imprimé (111) posé à côté sur le premier support de circuit imprimé (110) est prévu.

7. Élément fusible selon l'une ou plusieurs des revendications 1 à 6, **caractérisé en ce que**, au niveau de l'endroit (14) d'un premier support de circuit imprimé (110), sur lequel le fusible (12) est constitué d'un métal ou d'un alliage métallique (15), dans le deuxième support de circuit imprimé (111) posé à proximité du premier support de circuit imprimé (110), un espace creux (16) est prévu sous la forme d'un évidement dans le deuxième support de circuit imprimé (111).

8. Élément fusible selon l'une ou plusieurs des revendications 1 à 7, **caractérisé en ce que**, au niveau de l'endroit (14) d'un premier support de circuit imprimé (110), sur lequel le fusible (12) est constitué d'un métal ou d'un alliage métallique (15), dans un deuxième support de circuit imprimé (111) posé à proximité sur le premier support de circuit imprimé (110) ainsi qu'au niveau de l'endroit (14) du premier support de circuit imprimé (110), sur lequel le fusible (12) est réalisé, un espace creux (16, 160) est réalisé sous la forme d'évidements.

9. Élément fusible selon l'une ou plusieurs des revendications 7 ou 8, **caractérisé en ce que** l'espace creux (16) ou les espaces creux (16, 160) sont recouverts, sur le côté (17) opposé au fusible (12), d'une couche (18).

10. Élément fusible selon la revendication 9, **caractérisé en ce que** la couche (18) est une membrane.

11. Élément fusible selon la revendication 9, **caractérisé en ce que** la couche (18) est une couche flexible (18).

12. Élément fusible selon l'une ou plusieurs des revendications 9 à 11, **caractérisé en ce que** la couche (18) présente une structure en forme de film.

13. Élément fusible selon l'une ou plusieurs des revendications 9 à 12, **caractérisé en ce que** la couche (18) présente une couche métallique supplémentaire (19).

14. Élément fusible selon l'une ou plusieurs des revendications 1 à 13, **caractérisé en ce que** le support de circuit imprimé (11 ; 110, 111) comprend, au moins au niveau de la partie de fusion du fusible (12), une pluralité de trous de passage.

15. Élément fusible selon l'une ou plusieurs des revendications 1 à 14, **caractérisé en ce que** le métal ou l'alliage métallique (15) constituant la partie fusible du fusible (12) comprend une pluralité de trous de passage.

16. Élément fusible selon l'une ou plusieurs des revendications 7 à 15, **caractérisé en ce qu'**au moins un espace creux (16 ; 160) est rempli au moins partiellement d'un produit isolant.

17. Élément fusible selon l'une ou plusieurs des revendications 9 à 16, **caractérisé en ce que** la surface (20), dans laquelle la couche (18) est réalisée, définit globalement la surface du corps (21) du fusible (12) dans le plan.

18. Élément fusible selon l'une ou plusieurs des revendications 9 à 17, **caractérisé en ce qu'**au moins l'épaisseur de deux supports de circuits imprimés (110, 111) disposés l'un à côté de l'autre définit, en plus de l'épaisseur du conducteur constituant la partie fusible de l'élément fusible (10), l'épaisseur du corps (21) de l'élément fusible (10).

19. Élément fusible selon l'une ou plusieurs des revendications 1 à 18, **caractérisé en ce que** les deux extrémités (22, 23) de la partie fusible de l'élément fusible (10) sont munies de contacts de raccordement (24, 25).

20. Élément fusible selon la revendication 19, **caractérisé en ce que**, lors d'une formation tridimensionnelle du corps (21) constituant l'élément fusible (10), les contacts de raccordement (24, 25) sont reliés à l'aide de liaisons de contact avec les deux extrémités (22, 23) de la partie fusible du fusible (12).
